(19) Europäisches Patentamt
European Patent Office
Office européen des brevets

(11) **EP 4 553 059 A1**

(12) **EUROPEAN PATENT APPLICATION**
published in accordance with Art. 153(4) EPC

(43) Date of publication:
**14.05.2025 Bulletin 2025/20**

(21) Application number: **23835383.3**

(22) Date of filing: **27.06.2023**

(51) International Patent Classification (IPC):
**C04B 37/02** (2006.01)   **B32B 15/04** (2006.01)
**H05K 1/03** (2006.01)

(52) Cooperative Patent Classification (CPC):
**H01L 23/49861; B32B 15/04; C04B 37/02;
H01L 23/15; H01L 23/49866; H05K 1/03;**
H01L 21/4821

(86) International application number:
**PCT/JP2023/023831**

(87) International publication number:
**WO 2024/009851 (11.01.2024 Gazette 2024/02)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **05.07.2022 JP 2022108066**

(71) Applicants:
• **Kabushiki Kaisha Toshiba**
**Tokyo 105-0023 (JP)**

• **Toshiba Materials Co., Ltd.**
**Isogo-Ku**
**Yokohama-Shi**
**Kanagawa 235-0032 (JP)**

(72) Inventors:
• **FUJISAWA, Sachiko**
**Yokohama-shi, Kanagawa 235-0032 (JP)**
• **SUENAGA, Seiichi**
**Yokohama-shi, Kanagawa 235-0032 (JP)**
• **MORI, Yoichiro**
**Yokohama-shi, Kanagawa 235-0032 (JP)**

(74) Representative: **Henkel & Partner mbB**
**Patentanwaltskanzlei, Rechtsanwaltskanzlei**
**Maximiliansplatz 21**
**80333 München (DE)**

(54) **BONDED BODY, CERAMIC CIRCUIT BOARD, SEMICONDUCTOR DEVICE, AND METHOD FOR MANUFACTURING BONDED BODY**

(57)     Provided is a ceramic circuit board that is capable of suppressing a decrease in conductivity of a copper plate while maintaining bonding strength. A bonded body according to an embodiment comprises a ceramic substrate, a copper plate, and a bonding layer that bonds the ceramic substrate and the copper plate. The bonding layer contains Ag, Cu, an active metal, and a first element. The first element is one or two selected from Sn and In. As determined by SEM-EDX analysis of an arbitrary cross section, when a point at which a detection amount of Cu is not less than 80 mass% and at which a change in slope in a graph of the detection amount of Cu is the largest is assumed to be a first measurement point, a detection amount of the first element (mass%)/a detection amount of Ag (mass%) at the first measurement point is within the range of 0-0.4. The detection amount of the first element (mass%)/the detection amount of Ag (mass%) at the first measurement point is preferably within the range of 005-02.

FIG. 5

**Description**

[Technical Field]

Embodiments described below relate generally to a bonded body, a ceramic circuit board, a semiconductor device, and a method for manufacturing a bonded body.

[Background Art]

A bonded body of a ceramic substrate and a copper plate is used as a circuit board for mounting a semiconductor element or the like. International Publication No. 2017/056360 (Patent Literature 1) discusses a ceramic copper circuit board in which a ceramic substrate and a copper plate are bonded. In Patent Literature 1, the hardness and size of a bonding layer jutting part are controlled. Also, in International Publication No. 2018/199060 (Patent Literature 2), a diffusion region of Ag into a copper plate is controlled.

The ceramic circuit boards of Patent Literature 1 and Patent Literature 2 have excellent TCT (heat resistance cycle) characteristics. Guaranteed operating temperatures are expected to reach or exceed 170 °C, or even 200 °C as the performance of semiconductor elements increases. Also, downsizing of semiconductor devices to which semiconductor elements are mounted is being investigated. Power density is used to evaluate the performance of a semiconductor device. The power density can be calculated as "power density = (rated current×rated voltage×number of semiconductor elements mounted in module)/module volume". For example, the power density can be increased by increasing the number of semiconductor elements mounted in the module or reducing the volume of the module. To improve these two parameters, it is desirable to mount multiple semiconductor elements to a ceramic metal circuit board.

[Prior Art Documents]

[Patent Literature]

Patent Literature 1: International Publication No. 2017/056360
Patent Literature 2: International Publication No. 2018/199060

[Summary of Invention]

[Problem to be Solved by the Invention]

Generally, the electrical conductivity of oxygen-free copper is about 101% IACS. However, there have been cases of partial fluctuation of the electrical conductivity occurring in copper plates. The fluctuation of the electrical conductivity unfavorably affects the electrical resistance and the heat dissipation.

By investigating the causes, it was found that the diffusion amount of tin (Sn) or indium (In) into the copper plate is a cause. Active metal bonding is used in both Patent Literature 1 and Patent Literature 2. An active metal brazing material that includes Ag, Cu, and Ti is used in active metal bonding. Sn or In is added to the active metal brazing material to improve the bondability. The bondability is improved because Sn or In has the effect of lowering the melting point of the active metal brazing material.

For example, in active metal bonding, thermal bonding is performed at a high temperature of about 700 to 950 °C. In the thermal bonding process, the active metal brazing material components diffuse into the copper plate. The melting point of a AgCu alloy is about 780 °C, whereas the melting point of a AgSn alloy or a AgIn alloy is about 400 °C. The diffusion of Sn or In into the copper plate forms a large amount of a AgSn alloy or a AgIn alloy that has a low melting point.

Embodiments of the invention are directed to address such problems, and to provide a bonded body in which the occurrence of a AgSn alloy or a AgIn alloy is suppressed.

[Means for Solving the Problem]

A bonded body according to an embodiment includes a ceramic substrate, a copper plate, and a bonding layer bonding the ceramic substrate and the copper plate. The bonding layer includes Ag, Cu, an active metal, and a first element. The first element is one or two selected from Sn and In. A detection amount (mass%) of the first element divided by a detection amount (mass%) of Ag at a first measurement point is within a range of not less than 0 and not more than 0.4 when any cross section is analyzed by SEM-EDX, and when a location at which a detection amount of Cu is not less than 80 mass% and at which a change of a slope in a graph of the detection amount of Cu is largest is taken as the first measurement point.

[Brief Description of Drawings]

[FIG. 1]

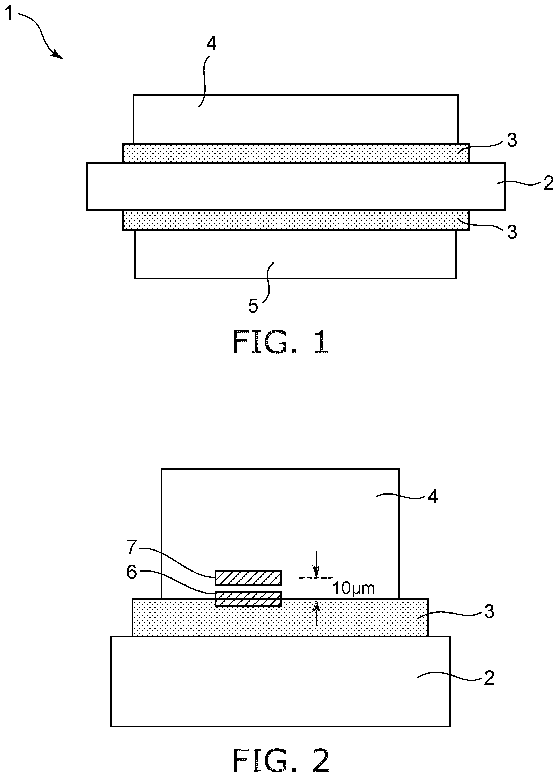

FIG. 1 is a drawing showing an example of a bonded body according to an embodiment.
[FIG. 2]
FIG. 2 is a drawing showing an example of a first measurement point and a second measurement point of the bonded body according to the embodiment.
[FIG. 3]

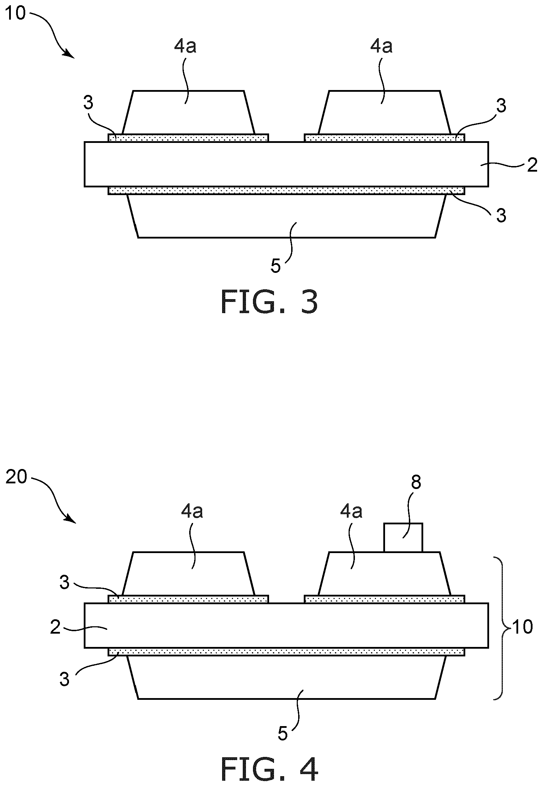

FIG. 3 is a drawing showing an example of a ceramic circuit board according to an embodiment.
[FIG. 4]
FIG. 4 is a drawing showing an example of a semiconductor device according to an embodiment.
[FIG. 5]

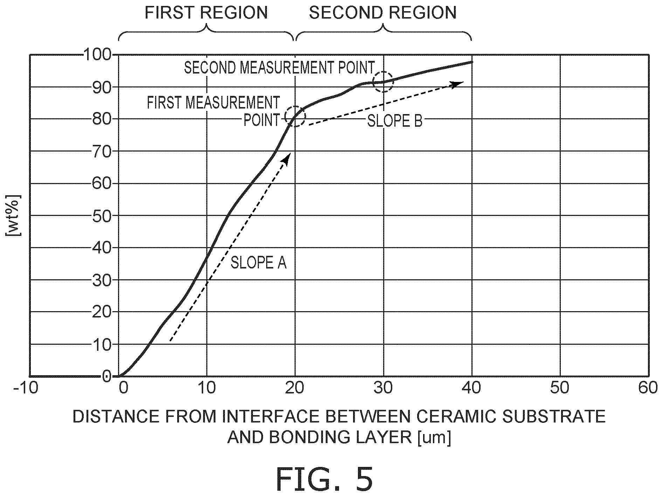

FIG. 5 is a figure showing an example of a graph of the Cu detection amount.

[Detailed Description]

A bonded body according to an embodiment includes a ceramic substrate, a copper plate, and a bonding layer bonding the ceramic substrate and the copper plate. The bonding layer includes Ag, Cu, an active metal, and a first element. The first element is one or two selected from Sn and In. A detection amount (mass%) of the first element divided by a detection amount (mass%) of Ag at a first measurement point is within a range of not less than 0 and not more than 0.4 when any cross section is analyzed by SEM-EDX, and when a location at which a detection amount of Cu is not less than 80 mass% and at which a change of a slope in a graph of the detection amount of Cu is largest is taken as the first measurement point.

FIG. 1 shows an example of a bonded body according to an embodiment. In FIG. 1, the reference numeral 1 is a bonded body, the reference numeral 2 is a ceramic substrate, the reference numeral 3 is a bonding layer, the reference numeral 4 is a copper plate (a front copper plate), and the reference numeral 5 is a copper plate (a back copper plate). FIG. 1 shows an example in which copper plates (the copper plate 4 and the copper plate 5) are bonded to two surfaces of the ceramic substrate 2. In the bonded body according to the embodiment, a copper plate may be bonded to only one surface of the ceramic substrate 2. Also, the number of copper plates bonded to one surface may be one, or may be multiple. The copper plate 4 that is bonded to the front surface is also called the front copper plate. The copper plate 5 that is bonded to the backside is also called the back copper plate.

In the bonded body 1, the ceramic substrate 2 and the copper plate 4 are bonded via the bonding layer 3. The bonding layer 3 includes Ag, Cu, an active metal, and a first element. The first element is one or two selected from Sn or In. The active metal is at least one selected from Ti (titanium), Zr (zirconium), and Hf (hafnium). A bonding technique that uses an active metal is called active metal bonding. That is, the bonded body according to the embodiment is a bonded body that is made with active metal bonding.

Any cross section of the bonded body is analyzed by scanning electron microscope-energy dispersive X-ray spectrometry (SEM-EDX). At this time, a location at which the detection amount (the concentration) of Cu is not less than 80 mass% and the change of the slope in a graph (a profile) of the detection amount of Cu is largest is taken as a first measurement point. In such a case, in the bonded body 1 according to the embodiment, the detection amount (mass%) of the first element divided by the detection amount (mass%) of Ag at the first measurement point is within the range of not less than 0.05 and not more than 0.4.

First, a technique for determining the first measurement point will be described. SEM-EDX is used in the measurement. A cross section is used in the SEM-EDX analysis. The cross section is a surface at which the bonded body 1 is cut along a direction perpendicular to the front surface of the ceramic substrate 2. Mirror polishing of the cross section to be measured is performed. JSM-7200F made by JEOL or an apparatus having equivalent or better performance is used in the SEM-EDX. The measurement conditions of an acceleration voltage of 15 kV, a magnification of 500 times, and a count rate of not less than 10,000 cps are set. ZAF correction is applied to the measurement result. JSM-7200F is a field emission scanning electron microscope (FE-SEM). By using FE-SEM, the measurement accuracy can be increased. FE-SEM is used in the measurement.

The count rate is the number of X-rays incident on the detector or counted by the detector in 1 second. The unit cps is an abbreviation of counts per second. ZAF is a method of correcting the characteristic X-ray intensity when performing quantitative analysis by using the three effects of (1) the atomic number (Z: atomic number) effect, (2) the absorption (A: absorption) effect, and (3) the fluorescence excitation (F: fluorescence) effect. If the SEM-EDX device includes a program for executing ZAF, the measurement result is corrected using the program.

An example of a method for determining the first measurement point will now be described with reference to the copper plate 4 (the front copper plate). The first measurement point of the copper plate 5 (the back copper plate) also can be similarly determined by replacing "copper plate 4" in the following description with "copper plate 5".

The dimensions of the SEM-EDX measurement area are set to 280 $\mu$m long$\times$2.5 $\mu$m thick; and area analysis of the cross section is performed. Area analysis is performed from the interface between the ceramic substrate 2 and the bonding layer 3 toward the copper plate 4 front surface. The measurement areas (280 $\mu$m long$\times$2.5 $\mu$m thick) are set not to overlap each other. The detection amounts of the elements are measured for each area analysis. A graph of the detection amount (the concentration) of Cu is generated based on the detection amount of Cu obtained by the area analysis. The location at which the detection amount in the graph of the detection amount of Cu is not less than 80 mass% and the change of the slope is largest is taken as the "first measurement point". The position of the interface between the ceramic substrate 2 and the bonding layer 3 is roughly discriminable based on the contrast difference of the SEM image.

The distance ($\mu$m) from the interface between the ceramic substrate 2 and the bonding layer 3 is used as the horizontal axis of the graph of Cu. The location at which the detection amount of Cu is 0 mass% is taken to be the interface between the ceramic substrate 2 and the bonding layer 3. The vertical axis of the graph of Cu is the mass% (wt%) of Cu.

Also, the graph of Cu is generated by the following procedure. First, detection amounts of each measurement area obtained by SEM-EDX are plotted to generate a scatter plot. Then, a graph is generated by connecting the points plotted on the scatter plot to each other with a smooth line. Functions of tabulation software are used to generate the scatter plot and the smooth line. Excel (registered trademark) of Microsoft Corporation is used as the tabulation software.

The location at which the change of the slope is largest is determined by a second-order derivative of the graph of Cu. That is, initially, a region in which the detection amount of Cu is not less than 80 mass% is determined from the graph of Cu. Then, the second-order derivative of the graph of Cu in the determined region is calculated. A minimum value is determined based on the value obtained by the second-order derivative. The point at which the minimum value is obtained is the location at which the change of the slope is largest, and is the first measurement point.

At the first measurement point, the mass% is analyzed also for components other than Cu. In the bonded body 1 according to the embodiment, the bonding layer 3 includes Ag, Cu, the active metal, and the first element. Therefore, other than Cu, analysis related to Ag, the active metal, and the first element also is performed at the first measurement point.

To generate the graph of Cu, it is effective to perform a qualitative analysis of bonding layer 3 beforehand. As a result of the qualitative analysis, the total mass of the metal components is calculated using the mass% of Cu as 100 mass%. As an example, Ag (silver), Cu (copper), Sn (tin), Ti (titanium), Si (silicon), O (oxygen), N (nitrogen), and C (carbon) are detected in the bonding layer 3 by the qualitative analysis of the bonding layer 3. In such a case, the metal components are Ag, Cu, Sn, and Ti. The Cu concentration is detected using the total of these elements as 100 mass%. That is, Si (silicon), O (oxygen), N (nitrogen), and C (carbon) are not counted as metal components. When the metal component is detected as an alloy or a compound, a conversion is made to the metallic element alone. That is, when a AgCu alloy is detected, the AgCu alloy is counted as the Ag amount and is counted as the Cu amount. If the analysis is performed using EDX, the detection amount that is converted to a metallic element alone can be measured. Quantitative analysis that uses EDX is prone to fluctuation of the measurement results of nonmetallic elements. Therefore, a method in which only the metallic elements are counted is favorable. That is, the graph of the detection amount (the concentration) of Cu is generated using the total of the metal components as 100 mass%.

FIG. 5 shows an example of a graph of the Cu detection amount. In the graph shown in FIG. 5, the horizontal axis is the distance from the interface between the ceramic substrate 2 and the bonding layer 3. The vertical axis is the detection amount (mass%) of Cu. The location at which the detection amount of Cu is 0 mass% is taken to be the interface between the ceramic substrate 2 and the bonding layer 3. The slope of the graph is calculated by software performing a second-order derivative. When software is included with the SEM-EDX device, the second-order derivative is performed using that software.

In the example shown in FIG. 5, the detection amount of Cu increases from the interface between the ceramic substrate 2 and the bonding layer 3 toward the copper plate 4. The detection amount of Cu exceeds 80 mass% at a distance of about 19.5 $\mu$m. Then, the rate of increase of the detection amount decreases at a distance of 20 $\mu$m. In other words, a change point of the slope is present in the graph. When the second-order derivative is performed, a minimum value is obtained at the change point. The change point of the slope is the first measurement point.

Here, the region from the interface between the ceramic substrate 2 and the bonding layer 3 to the first measurement point is taken as a "first region". The region at the side opposite to the first region with respect to the first measurement point is taken as a "second region". Also, the slope of the detection amount of Cu in the first region is taken as a "slope A". The slope of the detection amount of Cu in the second region is taken as a "slope B". It is favorable for the ratio of the slope B to the slope A to be not more than 0.5.

In the graph shown in FIG. 5, the ratio of the slope B of the detection amount of Cu in the second region to the slope A of the detection amount of Cu in the first region is 0.26. Slope B/slope A being not more than 0.5 means that a change point is present at which the Ag diffusion amount decreases. The change point at which the Ag diffusion amount decreases is considered to be the boundary between the bonding layer 3 and the copper plate 4. The presence of a change point at which the slope B/slope A reaches or drops below 0.5 means that the Ag diffusion amount into the copper plate 4 is suppressed. The absence of a change point at which the slope B/slope A reaches or drops below 0.5 means that the Ag diffusion amount into the copper plate is high.

The bonded body 1 according to the embodiment is characterized in that the detection amount (mass%) of the first element divided by the detection amount (mass%) of Ag is within the range of not less than 0 and not more than 0.4 at the first measurement point. This means that the Sn amount or the In amount with respect to the Ag amount is low at the first measurement point.

A AgSn alloy or AgIn is formed when Sn or In reacts with Ag. The melting point of the AgSn alloy decreases as the Sn amount included in the AgSn alloy increases. For example, the melting point of a solid solution of AgSn is about 200 °C to 500 °C. A AgIn alloy also has a similar tendency. The melting point of a CuSn alloy is 400 °C to 700 °C; and the melting point drops as the Sn amount included in the alloy increases. A CuIn alloy also has a similar tendency. On the other hand, the melting point of a AgCu eutectic solid is about 780 °C.

At the first measurement point, the detection amount (mass%) of the first element divided by the detection amount (mass%) of Ag being not less than 0 and not more than 0.4 means that the diffusion amount of the first element into the copper plate 4 is suppressed. When the detection amount (mass%) of the first element divided by the detection amount (mass%) of Ag is greater than 0.4, an alloy that has a low electrical conductivity is formed. When the alloy having the low electrical conductivity is formed, the electrical conductivity of the copper plate 4 is reduced.

In JIS-H-3100 (ISO 1337, etc.), the electrical conductivity of oxygen-free copper is not less than 98% IACS. In contrast, the electrical conductivity of Sn is about 15% IACS; and the electrical conductivity of In is about 20% IACS. When the diffusion amount of the first element into the copper plate 4 increases, a portion of low electrical conductivity is formed inside the copper plate 4. If the detection amount (mass%) of the first element divided by the detection amount (mass%) of Ag exceeds 0.4, the diffusion amount of the first element into the copper plate 4 is high, and the electrical conductivity of the copper plate 4 decreases to be not less than 10%.

The detection amount (mass%) of the first element divided by the detection amount (mass%) of Ag being 0 means that the first element is below the detection limit. When the detection amount (mass%) of the first element divided by the detection amount (mass%) of Ag is less than 0.05 (including 0), an alloy that has a low electrical conductivity is not formed. On the other hand, the components of the bonding layer 3 do not diffuse into the copper plate; and there is a possibility that the bonding strength may be insufficient.

By controlling the detection amount (mass%) of the first element divided by the detection amount (mass%) of Ag, both the suppression of the electrical conductivity reduction of the copper plate 4 and the increase of the bonding strength can be realized. It is therefore favorable for the detection amount (mass%) of the first element divided by the detection amount (mass%) of Ag to be not less than 0 and not more than 0.4, and more favorably not less than 0.05 and not more than 0.2. When both Sn and In are detected at the first measurement point, it is favorable for the total detection amount (mass%) of Sn and In divided by the detection amount (mass%) of Ag to be within the range of not less than 0.05 and not more than 0.4.

In the bonded body 1 according to the embodiment, the detection amount (mass%) of the first element divided by the detection amount (mass%) of Ag is within the range of not less than 0 and not more than 0.4 at each first measurement point. That is, when two or more areas at mutually-different in-plane-direction positions in one cross section are analyzed by SEM-EDX, the detection amount (mass%) of the first element divided by the detection amount (mass%) of Ag is within the range of not less than 0 and not more than 0.4 at the first measurement point in each of the areas.

Also, the first measurement point is positioned at substantially the boundary between the bonding layer 3 and the copper plate 4 (or the copper plate 5). The bonding layer 3 includes Cu, Ag, the first element, etc. In the bonding process, these components diffuse from the boundary between the bonding layer 3 and the copper plate 4 into the copper plate 4. The reduction of the amount of the first element at the first measurement point means that the diffusion amount of the first element into the copper plate 4 also is suppressed.

At the first measurement point, it is favorable for the detection amount of Ag to be within the range of not less than 3 mass% but less than 20 mass%. The diffusion of Ag from the bonding layer 3 into the copper plate 4 effectively increases the bonding strength. On the other hand, when too much Ag diffuses into the copper plate 4, there is a possibility that Ag ion migration may be caused. The detection amount of Ag at the first measurement point being not less than 3 mass% but less than 20 mass% means that excessive diffusion of Ag into the copper plate 4 is suppressed, and the Ag necessary for the bonding between the bonding layer 3 and the copper plate 4 is present at the boundary between the bonding layer 3 and the copper plate 4. It is therefore favorable for the detection amount of Ag at the first measurement point to be not less than 3 mass% but less than 20 mass%.

At the first measurement point, it is favorable for the detection amount (mass%) of the active metal divided by the detection amount (mass%) of Ag to be within the range of not less than 0 and not more than 0.1. The active metal can increase the bonding strength by reacting with the ceramic substrate. For example, when Ti is used as the active metal and a silicon nitride substrate is used as the ceramic substrate, the Ti and the silicon nitride substrate react to form a titanium nitride (TiN) layer. At the first measurement point, the detection amount (mass%) of the active metal divided by the Ag detection amount (mass%) being greater than 0.1 indicates the presence of much active metal that did not react with the ceramic substrate 2. By setting the detection amount (mass%) of the active metal at the first measurement point divided by the Ag detection amount (mass%) at the first measurement point to be not more than 0.1, the active metal that contributes to the reaction with the ceramic substrate 2 can be increased.

A location shifted 10 μm from the first measurement point toward the front surface of the copper plate 4 is taken as a "second measurement point". In such a case, it is favorable for the detection amount (mass%) of Ag at the second measurement point divided by the detection amount of Ag at the first measurement point to be within the range of not less than 0.1 and not more than 0.7.

FIG. 2 is a conceptual view of the first and second measurements points. In FIG. 2, the reference numeral 3 is a bonding layer, the reference numeral 4 is a copper plate, the reference numeral 6 is a first measurement point, and the reference numeral 7 is a second measurement point. The location at which the measurement area (280 μm long×2.5 μm thick) is shifted 10 μm from the first measurement point toward the front surface of the copper plate 4 is the second measurement point. The second measurement point is set so that the distance from the midpoint in the thickness direction of the measurement area that is the first measurement point to the midpoint in the thickness direction of the measurement area that is the second measurement point is 10 μm.

The detection amount (mass%) of Ag at the second measurement point divided by the detection amount of Ag at the first measurement point being within the range of not less than 0.1 and not more than 0.7 means that the Ag diffusion amount decreases toward the front surface of the copper plate 4. That is, this shows that the Ag diffusion amount decreases within the short distance of 10 μm.

It is favorable for the detection amount (mass%) of the first element divided by the detection amount (mass%) of Ag at the second measurement point to be within the range of not less than 0 and not more than 0.1. By reducing the diffusion amount of the first element at the second measurement point, the formation amount of an alloy having a low electrical conductivity inside the copper plate 4 can be reduced.

It is favorable for the detection amount (mass%) of the active metal divided by the detection amount (mass%) of Ag at the second measurement point to be within the range of not less than 0 and not more than 0.1. By reducing the diffusion amount of the active metal at the second measurement point, the active metal that contributes to the reaction between the ceramic substrate 2 and the bonding layer 3 can be increased.

It is favorable for a Ag diffusion region to be present between the ceramic substrate 2 and a point shifted 30 μm from the first measurement point toward the front surface of the copper plate 4. That is, it is favorable for a Ag diffusion region not to be present in the region separated by 30 μm or more from the first measurement point toward the front surface of the copper plate 4. The Ag diffusion region is a cluster of measurement areas (280 μm long×2.5 μm thick) in which not less than 0.01 mass% of Ag is detected. The detection amount of Ag being less than 0.01 mass% means being below the detection limit (including 0 mass%). By reducing the Ag diffusion region, the Ag ion migration can be suppressed.

When Ag diffuses from the bonding layer 3 to the front surface of the copper plate 4, the Ag precipitates at the front surface of the copper plate 4. Ag ion migration is a phenomenon in which the Ag that precipitated at the front surface of the copper plate 4 is ionized and moves. The Ag that moves precipitates at another location. This causes insulation defects. Ag ion migration occurs easily when a voltage is applied to the bonded body in an environment of high humidity. By reducing the Ag diffusion region in the copper plate 4, the diffusion of Ag into the vicinity of the front surface of the copper plate 4 can be suppressed. As a result, the presence of Ag at the front surface of the copper plate 4 can be prevented. As a result, the occurrence of Ag ion migration can be suppressed. Also, by reducing the diffusion amount of Sn or In, the migration of Sn or In also can be suppressed.

Various members are applicable to the ceramic substrate 2. Examples of the ceramic substrate include a silicon nitride substrate, an aluminum nitride substrate, an alumina substrate, a zirconium substrate, and an Alusil substrate. An Alusil substrate is a ceramic sintered body in which alumina and zirconia are mixed. It is favorable for the thickness of the ceramic substrate 2 to be within the range of not less than 0.2 mm and not more than 3 mm.

It is favorable for the three-point bending strength of the silicon nitride substrate to be not less than 600 MPa. It is favorable for the thermal conductivity of the silicon nitride substrate to be not less than 80 W/m·K. By increasing the strength of the silicon nitride substrate, the substrate can be thin. It is therefore favorable for the three-point bending strength of the silicon nitride substrate to be not less than 600 MPa, and more favorably not less than 700 MPa. The thickness of the silicon nitride substrate can be thin, and can be not more than 2 mm, or even not more than 0.40 mm.

The three-point bending strength of an aluminum nitride substrate is about 300 to 450 MPa. On the other hand, the thermal conductivity of an aluminum nitride substrate is not less than 160 W/m·K. Because the strength of an aluminum nitride substrate is low, it is favorable for the thickness of the substrate to be not less than 0.60 mm. Although the three-point bending strength of an aluminum oxide substrate is about 300 to 450 MPa, an aluminum oxide substrate is inexpensive. Although the three-point bending strength of an Alusil substrate is high and is about 550 MPa, the thermal conductivity of an Alusil substrate is about 30 to 50 W/m·K.

A silicon nitride substrate is favorable as the ceramic substrate 2. A silicon nitride substrate has high strength, and therefore can withstand the heat shrinkage of a mold resin. Also, by using a silicon nitride substrate having a thermal conductivity of not less than 80 W/m·K, the heat dissipation also can be improved.

Silicon nitride substrates and aluminum nitride substrates are called nitride ceramic substrates. When a nitride ceramic and the copper plate 4 are bonded by active metal bonding, the active metal and the nitride ceramic substrate react to form an active metal nitride layer inside the bonding layer 3. When Ti is used as the active metal, a titanium nitride (TiN) layer is formed. The bonding strength can be increased by the formation of the active metal nitride layer.

Aluminum oxide substrates, zirconium oxide substrates, and Alusil substrates are called oxide ceramic substrates. When an oxide ceramic substrate and the copper plate 4 are bonded by active metal bonding, the active metal and the oxide ceramic substrate react to form an active metal oxide layer. When Ti is used as the active metal, a titanium oxide ($TiO_2$) layer is formed. The bonding strength can be increased by the formation of the active metal oxide layer.

It is favorable for the thickness of the copper plate 4 to be not less than 0.3 mm. By making the copper plate 4 thick, the heat dissipation can be improved. The current-carrying capacity of the copper plate 4 can be increased. It is therefore favorable for the thickness of the copper plate 4 to be not less than 0.3 mm, and more favorably not less than 0.6 mm. Although the upper limit of the thickness of the copper plate is not particularly limited, it is favorable for the upper limit to be not more than 5 mm. When greater than 5 mm, there is a possibility that circuit formation in the copper plate 4 by etching may be difficult. Also, it is favorable for the thicknesses of the front copper plate and the back copper plate each to be not less than 0.3 mm.

A copper alloy plate may be used as the copper plate. It is favorable for the copper plate to be an oxygen-free copper plate. As defined in JIS-H-3100, oxygen-free copper has a copper purity of not less than 99.96 wt%. JIS-H-3100 corresponds to ISO 1337, etc.

Such a bonded body is applicable to a ceramic circuit board. Also, the ceramic circuit board is applicable to a semiconductor device to which a semiconductor element is mounted.

FIG. 3 shows an example of a ceramic circuit board according to an embodiment. FIG. 4 shows an example of a semiconductor device according to an embodiment. In FIGS. 3 and 4, the reference numeral 4a is a copper circuit, the reference numeral 8 is a semiconductor element, the reference numeral 10 is a ceramic circuit board, and the reference numeral 20 is a semiconductor device.

The ceramic circuit board 10 is made by providing the copper plate 4 of the bonded body 1 with a circuit configuration. An etching process or the like is used to provide the circuit configuration. FIG. 3 shows an example in which the copper circuit 4a is located at the front side of the ceramic substrate 2; and the back copper plate 5 is used as a heat dissipation plate. For example, one or more copper circuits 4a are formed by providing the front copper plate 4 shown in FIG. 1 with a circuit configuration by an etching process. In the ceramic circuit board 10 according to the embodiment, both the front copper plate 4 and the back copper plate 5 may be provided with circuit configurations. Also, FIG. 3 shows an example in which two copper circuits 4a are included. It is sufficient for the ceramic circuit board 10 to include the necessary number of copper circuits 4a.

In the semiconductor device 20, the semiconductor element 8 is mounted to the ceramic circuit board 10. FIG. 4 shows an example in which one semiconductor element 8 is mounted. The structure of the semiconductor device 20 according to the embodiment is not limited to the illustrated example; multiple semiconductor elements 8 may be mounted. Multiple semiconductor elements 8 may be mounted to one copper circuit 4a. A leadframe, wire bonding, terminals, etc., which are not illustrated, may be bonded to the copper circuit 4a. Also, a mold resin that covers the semiconductor element 8 may be included as necessary.

A method for manufacturing the bonded body 1 according to the embodiment will now be described. As long as the bonded body 1 according to the embodiment has the configuration described above, the method for manufacturing the bonded body 1 is not limited. A method for manufacturing the bonded body 1 with a high yield will now be described.

First, the ceramic substrate 2 is prepared. It is favorable for the ceramic substrate 2 to be one selected from a silicon nitride substrate, an aluminum nitride substrate, an alumina substrate, a zirconium substrate, and an Alusil substrate. Also, the copper plate 4 is prepared.

Then, an active metal brazing material is prepared. First, a powder of the components included in the active metal brazing material is prepared. The active metal is at least one selected from Ti, Zr, and Hf. One or two selected from a simple metal of an active metal and a hydride of an active metal are used as the active metal. For example, when the active metal is Ti, Ti powder or titanium hydride ($TiH_2$) powder is used. Also, a Ag powder, a Cu powder, and a powder of the first element are prepared.

It is favorable for the ratio of Ag to be within the range of not less than 40 mass% and not more than 95 mass%. It is favorable for the ratio of Cu to be within the range of not less than 3 mass% and not more than 50 mass%. It is favorable for the ratio of the total of the active metal and the active metal hydride to be within the range of not less than 1 mass% and not more than 15 mass%. It is favorable for the ratio of the total of Sn and In to be within the range of not less than 1 mass% and not more than 30 mass%.

Ag and Cu are elements used as major components of the bonding layer 3. Also, the active metal or the active metal hydride is a component that reacts with the ceramic substrate 2 to obtain a secure bond. Sn or In has the effect of lowering the melting point of the active metal brazing material.

Not less than 0.1 mass% and not more than 2 mass% of carbon (C) may be added to the active metal brazing material. Not less than 0.1 mass% and not more than 10 mass% of at least one selected from tungsten (W), molybdenum (Mo), and rhenium (Re) may be added to the active metal brazing material. The fluidity of the active metal brazing material can be controlled by adding carbon, tungsten, molybdenum, or rhenium. Magnesium (Mg) may be added to the active metal brazing material.

The component ratios of the active metal brazing material described above are ratios when the total of the metal components is taken to be 100 mass%. For example, when a titanium nitride powder is used, the mass% of titanium nitride is controlled to be within the range described above. The mass of organic substances such as the binder, etc., is not counted. The active metal brazing material paste is prepared by mixing the brazing material components and adding a binder, etc.

Then, a stacked body that includes the ceramic substrate 2, the active metal brazing material paste layer, and the copper plate 4 is made. The active metal brazing material paste is coated onto the ceramic substrate 2; and the copper plate 4 is placed on the active metal brazing material paste. The active metal brazing material paste may be coated onto two surfaces of the ceramic substrate 2; and the copper plates 4 may be placed respectively on the two surfaces. Or, the active metal brazing material paste may be coated onto the copper plate 4; and the ceramic substrate 2 may be placed on the active metal brazing material paste. The number of stacks of the ceramic substrate 2 and the copper plate 4 is increased as necessary. For example, the number of stacks may be increased such as copper plate/active metal brazing material paste layer/ceramic substrate/active metal brazing material paste layer/copper plate/active metal brazing material paste layer/ceramic substrate/active metal brazing material paste layer/copper plate. The stacked body that includes the ceramic substrate 2, the active metal brazing material paste layer, and the copper plate 4 is made by this process.

Then, a thermal bonding process is performed. It is favorable for the bonding temperature to be within the range of not less than 700 °C and not more than 950 °C. The bonding temperature refers to a temperature that is held for not less than a prescribed period. When the active metal brazing material described above is used, the ceramic substrate 2 and the copper plate 4 can be bonded within the range of not less than 700 °C and 950 °C. Accordingly, the bonding temperature is set to be within the range of not less than 700 °C and 950 °C. When the bonding temperature is less than 700 °C, there is a possibility that the bonding strength may be insufficient. When the bonding temperature is greater than 950 °C, there is a possibility that the diffusion amount of Ag, the active metal, or the first element into the copper plate 4 may be increased. It is therefore favorable for the bonding temperature to be within the range of not less than 700 °C and not more than 950 °C, and more favorably within the range of not less than 850 °C and not more than 920 °C.

Also, it is favorable for the holding time at the bonding temperature to be within the range of not less than 3 minutes and not more than 60 minutes. Considering the temperature fluctuation inside the furnace, the time that the stacked body is held in a temperature range within the range of the bonding temperature ±30 °C is counted as the holding time at the bonding temperature. For example, when the bonding temperature is 880 °C, the time that the stacked body is held in the temperature range of 880 °C±30 °C is the holding time at the bonding temperature.

When the holding time at the bonding temperature is less than 3 minutes, there is a possibility that the bonding strength may be insufficient. When the holding time at the bonding temperature is greater than 60 minutes, the time of being exposed to a high temperature lengthens. There is a possibility that the diffusion amount of Ag, the active metal, or the first element into the copper plate 4 may increase. It is therefore favorable for the holding time at the bonding temperature to be within the range of not less than 3 minutes and not more than 60 minutes, and more favorably within the range of not less than 5 minutes and not more than 40 minutes.

It is favorable to use a continuous furnace in the thermal bonding process. The stacked body can be bonded in a nitrogen atmosphere by using a continuous furnace. A nitrogen atmosphere refers to an atmosphere in which nitrogen is not less than 98 vol% and not more than 100 vol%. In a continuous furnace, the stacked body can be thermally bonded while conveying the article with a belt conveyor, etc. By using a continuous furnace, the temperature rise time from room temperature to the bonding temperature and the temperature fall time from the bonding temperature to room temperature can be reduced. As a result, the time that the stacked body is exposed to a high temperature for longer than necessary can be reduced.

For example, in conventional active metal bonding, the stacked body is thermally bonded in a vacuum. A batch furnace is used to bond in a vacuum. In a batch furnace, the stacked body is placed in a sealed space and heated. When a batch furnace is used, it takes time to raise and lower the temperature due to the heat capacity of the furnace body (the sealed space) itself. It is therefore necessary to adjust the temperature of the furnace body; and the temperature raising process and the temperature lowering process take time. The temperature raising rate and the temperature lowering rate of a batch furnace are about 1 to 3 °C/min. In a batch furnace, the time to return to room temperature after holding at the bonding temperature is long. Therefore, the bonded body is exposed to a high temperature for a long time. As a result, the diffusion amount of Ag and the first element into the copper plate 4 is increased. On the other hand, in a continuous furnace, the sample passes through the furnace, and so the heating time is determined by only the heat capacity of the sample itself. Therefore, the temperature raising rate and the temperature lowering rate can be fast.

When the thermal bonding process is performed using a continuous furnace, it is favorable for the active metal content of the active metal brazing material to be not less than 5 mass%. In a continuous furnace, the stacked body is bonded in an inert atmosphere. Examples of the inert atmosphere include a nitrogen atmosphere or an argon atmosphere. A nitrogen atmosphere is used when considering the cost. On the other hand, the active metal has high reactivity with nitrogen. By setting the content of the active metal inside the active metal brazing material to be not less than 5 mass%, the ratio of the active metal contributing to the bonding without reacting with the nitrogen atmosphere can be increased. Therefore, the yield when using the continuous furnace can be increased.

When a continuous furnace is used, the temperature raising rate of the stacked body and the temperature lowering rate of the bonded body can be set to be not less than 15 °C/min. By increasing the temperature raising rate and the temperature lowering rate, the time that the stacked body or the bonded body is exposed to a high temperature can be reduced. Although the upper limits of the temperature raising rate and the temperature lowering rate are not particularly limited, it is favorable for the upper limits to be not more than 100 °C/min. When the upper limits are greater than 100 °C/min, there is a possibility that the temperature change may be too large, which may cause distortion of the bonded body.

It is favorable for the difference between the temperature raising rate and the temperature lowering rate to be not more than 20 °C/min. The difference between the temperature raising rate and the temperature lowering rate is represented by |temperature raising rate - temperature lowering rate|. That is, it is favorable for |temperature raising rate - temperature lowering rate| $\leq$ 20 °C/min. By reducing the difference between the temperature raising rate and the temperature lowering rate, the diffusion amount of the active metal brazing material components can be made uniform. As a result, the detection amount (mass%) of the first element divided by the detection amount (mass%) of Ag can be within the range of not less than 0 and not more than 0.4 when measured at any first measurement point of the bonded body 1.

The temperature of the stacked body is used as the temperature profile of the thermal bonding process. To measure the temperature of the stacked body, a method in which a thermocouple is mounted to the stacked body and passed through the continuous furnace is effective. The temperature raising process, the thermal bonding process, and the temperature lowering process are performed, and the temperature profile of the stacked body is measured. The temperature raising rate, the holding time at the bonding temperature, and the temperature lowering rate are calculated based on the temperature profile. Here, the temperature raising rate refers to the average temperature raising rate from 200 °C to the bonding temperature. The temperature lowering rate refers to the average temperature lowering rate from the bonding temperature to 200 °C.

The space that the temperature raising process is performed may be divided into multiple zones. For example, the multiple zones include a room temperature zone, a zone from room temperature to 200 °C, a zone from 200 °C to 400 °C, a zone from 400 °C to 600 °C, a zone from 600 °C to the bonding temperature, and a zone in which the stacked body is held at the bonding temperature. The temperature of the stacked body is sequentially increased in the zones. The temperature raising process is performed by the stacked body passing through the multiple zones.

In the temperature raising process, it is favorable for the temperature of the stacked body in the initial processing zone of heating the stacked body to be within the range of not less than 150 °C and not more than 400 °C. The initial processing zone is the zone of the continuous furnace in which the stacked body is initially heated. According to the method for manufacturing the bonded body according to the embodiment, the temperature raising rate from 200 °C to the bonding temperature in the temperature raising process is controlled. By setting the temperature of the stacked body in the initial processing zone to be within the range of not less than 150 °C and not more than 400 °C, the temperature raising rate from 200 °C is easily controlled. It is therefore favorable for the temperature of the stacked body in the initial processing zone to be within the range of not less than 150 °C and not more than 400 °C, and more favorably within the range of not less than 180 °C and not more than 370 °C. Also, within this temperature range, the effect of degreasing the binder inside the brazing material paste also is obtained. The removal of the binder is effective for suppressing diffusion of the active metal brazing material components into the copper plate 4.

It is favorable for the average conveyance speed of the stacked body to be not less than 1 cm/min. The average conveyance speed is the average value of the movement speed of the stacked body when conveying through the temperature raising process, the thermal bonding process, and the temperature lowering process. When the average conveyance speed is less than 1 cm/min, the conveyance speed is slow, and so there is a possibility that the suitability for mass production may degrade. When a process of stopping the conveyance is included, the conveyance speed in such a process is counted as 0 cm/min. For example, when a conveyance for 30 minutes at a conveyance speed of 5 cm/min and a conveyance for 10 minutes at a conveyance speed of 10 cm/min are performed, the average conveyance speed is 6.3 cm/min. When a conveyance for 60 minutes at a conveyance speed of 5 cm/min is performed, and the conveyance is stopped for 30 minutes, the average conveyance speed is 3.3 cm/min.

Although the upper limit of the average conveyance speed is not particularly limited, it is favorable for the upper limit to be not more than 30 cm/min. When the average conveyance speed is fast, the conveyance distance necessary for the temperature rise, the thermal bonding, and the temperature lowering lengthens, which may require a larger manufacturing apparatus. Also, when the average conveyance speed is fast, there is a possibility that the conduction of heat to the stacked body may be nonuniform. It is therefore favorable for the average conveyance speed to be within the range of not less than 1 cm/min and not more than 30 cm/min, and more favorably within the range of not less than 8 cm/min and not more than 20 cm/min. Within this range, the conduction of heat to the stacked body can be uniform, and so the suitability for mass production can be improved.

The bonded body 1 can be manufactured by the processes described above. Then, a process of providing the copper plate 4 with a circuit configuration is performed. To provide the circuit configuration, a method of performing an etching process of the copper plate 4 is effective. The copper plate 4 is patterned into the copper circuit 4a in the etching process. By providing the copper plate 4 of the bonded body 1 with the circuit configuration, the ceramic circuit board 10 is obtained. Or, the copper circuit 4a may be made by patterning the copper plate 4 into a circuit configuration beforehand. The ceramic circuit board 10 is obtained by bonding the copper circuit 4a to the ceramic substrate 2. A large bonded body may be made, and multi-part manufacturing may be performed. In other words, one bonded body may be subdivided into multiple bonded bodies 1. Also, the semiconductor device 20 can be manufactured by mounting the semiconductor element 8, etc., to the ceramic circuit board 10 thus obtained.

(Examples)

(Examples 1 to 8 and comparative examples 1 to 2)

A silicon nitride substrate, an aluminum nitride substrate, and an aluminum oxide substrate were prepared as ceramic substrates. The thermal conductivity of the silicon nitride substrate was 90 W/m·K, and the three-point bending strength was 650 MPa. The thermal conductivity of the aluminum nitride substrate was 170 W/m·K, and the three-point bending strength was 400 MPa. The thermal conductivity of the aluminum oxide substrate was 20 W/m·K, and the three-point bending strength was 430 MPa. The longitudinal length, lateral length, and thickness of each substrate were as shown in Table 1.

[Table 1]

| Ceramic substrate | Length×width×thickness (mm) |
|---|---|
| Silicon nitride substrate | 190×140×0.32 |
| Aluminum nitride substrate | 100×100×0.635 |
| Aluminum oxide substrate | 200×180×0.635 |

Then, the active metal brazing materials shown in Table 2 were prepared. In Table 2, the total of the brazing material components was used as 100 mass%, and the compositions of the active metal brazing materials are shown.

[Table 2]

| Brazing material layer | Active metal brazing material composition |
|---|---|
| Brazing material 1 | Ag(40.9), Cu(35.3), Sn(15), TiH$_2$(8.7), C(0.1) |
| Brazing material 2 | Ag(65). Cu(20), Sn(10), TiH$_2$(5) |
| Brazing material 3 | Ag(90), Cu(4), Sn(4), TiH$_2$(2) |
| Brazing material 4 | Ag(54.8). Cu(25). Sn(10), TiH$_2$(10), C(0.2) |
| Brazing material 5 | Ag(41). Cu(22). Sn(25). TiH$_2$(12) |

Then, copper plates were prepared. Oxygen-free copper was used as the copper plates. The thicknesses of the copper plates were as shown in Table 3.

[Table 3]

| | Thickness (mm) |
|---|---|
| Copper plate 1 | 0.3 |
| Copper plate 2 | 0.8 |

A binder and the like were added to the active metal brazing material to prepare an active metal brazing material paste. The active metal brazing material paste was coated onto the ceramic substrate. The stacked body was made by placing the copper plate on the ceramic substrate. In the stacked body, the copper plates were placed respectively on two surfaces of the ceramic substrate with the active metal brazing material paste interposed. The combinations of the ceramic substrate, the active metal brazing material, and the copper plate in the stacked bodies were as shown in Table 4.

[Table 4]

|  | Ceramic substrate | Active metal brazing material | Copper plate |
|---|---|---|---|
| Stacked body1 | Silicon nitride substrate | Brazing material1 | Copper plate2 |
| Stacked body2 | Silicon nitride substrate | Brazing material3 | Copper plate2 |
| Stacked body3 | Aluminum nitride substrate | Brazing material2 | Copper plate1 |
| Stacked body4 | Aluminum oxide substrate | Brazing material2 | Copper plate1 |
| Stacked body5 | Silicon nitride substrate | Brazing material4 | Copper plate1 |
| Stacked body6 | Silicon nitride substrate | Brazing material4 | Copper plate2 |
| Stacked body7 | Silicon nitride substrate | Brazing material1 | Copper plate2 |
| Stacked body8 | Silicon nitride substrate | Brazing material1 | Copper plate2 |
| Stacked body9 | Silicon nitride substrate | Brazing material5 | Copper plate2 |

Then, a bonded body was manufactured by performing a thermal bonding process of the stacked body. For the examples 1 to 8 and the comparative example 1, the thermal bonding process was performed using a continuous furnace. For the comparative example 2, the thermal bonding process was performed using a vacuum batch furnace. The bonding conditions were as shown in Table 5.

[Table 5]

|  | Stacked body | Conveyance speed (cm/minutes) | Initial heating zone temperature of temperature raising process | Temperature raising rate (°C/minutes) | Bonding temperature (°C)· holding time (minutes) | Temperature lowering rate (°C/minutes) |
|---|---|---|---|---|---|---|
| Example1 | Stacked body1 | 3 | 160 | 30 | 850·40 | 30 |
| Example2 | Stacked body1 | 5 | 200 | 40 | 880·25 | 40 |
| Example3 | Stacked body2 | 8 | 250 | 60 | 940·15 | 60 |
| Example4 | Stacked body3 | 13 | 300 | 20 | 900·20 | 30 |
| Example5 | Stacked body4 | 15 | 350 | 50 | 880·30 | 40 |
| Example6 | Stacked body5 | 20 | 210 | 50 | 910·30 | 50 |
| Example7 | Stacked body6 | 25 | 220 | 50 | 920·20 | 50 |
| Example8 | Stacked body9 | 10 | 200 | 35 | 900·25 | 30 |
| Comparative example1 | Stacked body7 | 5 | 500 | 2 | 900·40 | 2 |

(continued)

| | Stacked body | Conveyance speed (cm/minutes) | Initial heating zone temperature of temperature raising process | Temperature raising rate (°C/minutes) | Bonding temperature (°C)· holding time (minutes) | Temperature lowering rate (°C/minutes) |
|---|---|---|---|---|---|---|
| Comparative example2 | Stacked body8 | - | - | 2 | 850·30 | 2 |

The temperature raising rate in Table 5 is the average temperature raising rate from 200°C to the bonding temperature. The temperature lowering rate is the average temperature lowering rate from the bonding temperature to 200 °C. The bonded body was made by this process.

Then, the diffusion state of the active metal brazing material components into the copper plate was checked for the bonded bodies of the examples and the comparative examples. Arbitrary cross sections of the bonded bodies were used to measure the diffusion state. The samples for the measurements were prepared by performing mirror finishing of the cross sections.

A graph of the detection amount of Cu was generated using SEM-EDX. JSM-7200F was used as SEM-EDX. The measurement area was set to be 280 $\mu$m long$\times$2.5 $\mu$m thick. The other measurement methods were as described above. The first measurement point, the second measurement point, and the Ag diffusion region were determined based on the graph of Cu. Also, the first measurement point was determined where the detection amount (the concentration) of Cu was not less than 80 mass% and the minimum value of the second-order derivative of the graph occurred. The results are shown in Table 6.

[Table 6]

| | First measurement point | | | Second measurement point | | | Ag diffusion region ≤ 30 $\mu$m? |
|---|---|---|---|---|---|---|---|
| | Sn/Ag mass ratio | Ti/Ag mass ratio | Ag detection amount (mass%) | Second measurement point Ag amount/ first measurement point Ag amount | Sn/Ag mass ratio | Ti/Ag mass ratio | |
| Example1 | 0.22 | 0.01 | 8 | 0.4 | 0.01 | <0.01 | YES |
| Example2 | 0.03 | 0.03 | 16 | 0.6 | 0.04 | <0.01 | YES |
| Example3 | 0.16 | <0.01 | 12 | 0.5 | 0.01 | <0.01 | YES |
| Example4 | 0.13 | <0.01 | 15 | 0.2 | <0.01 | <0.01 | YES |
| Example5 | 0.14 | <0.01 | 7 | 0.2 | <0.01 | <0.01 | YES |
| Example6 | 0.15 | 0.01 | 10 | 0.2 | 0.02 | <0.01 | YES |
| Example7 | 0.19 | 0.01 | 12 | 0.3 | 0.02 | <0.01 | YES |
| Example8 | 0.10 | 0.04 | 8 | 0.1 | 0.03 | <0.01 | YES |
| Comparative example1 | 0.5 | 0.03 | 10 | 0.8 | 0.2 | <0.01 | NO |
| Comparative example2 | 0.9 | 0.01 | 18 | 0.7 | 0.2 | 0.04 | NO |

It can be seen from Table 6 that the detection amount (mass%) of the first element divided by the detection amount (mass%) of Ag at the first measurement point was within the range of not less than 0 and not more than 0.4 for the bonded bodies according to the examples. The detection amount (mass%) of Ag at the second measurement point divided by the detection amount (mass%) of Ag at the first measurement point was within the range of not less than 0.1 and not more than 0.7. The Ag diffusion region for each was not more than 30 $\mu$m. The distance from the first measurement point to the second measurement point was 10 $\mu$m. It can be seen that the diffusion amount of the elements of Ag, Sn, etc., decreased at a short distance of 10 $\mu$m. Also, the slope of the detection amount of Cu in the second region divided by the slope of the detection amount of Cu in the first region was not more than 0.5 for each of the graphs of Cu of the bonded bodies according to the examples.

In contrast, according to the comparative example 1, a continuous furnace was used, but the temperature raising rate and the temperature lowering rate were slow. It is therefore considered that the heat amount applied to the stacked body was large, and the diffusion amount of Ag, Sn, etc., increased. A vacuum batch furnace was used for the comparative example 2. Compared to the continuous furnace, the thermal load on the stacked body in the batch furnace was large, and so the diffusion amount of Ag and Sn increased. Also, the slope of the detection amount of Cu in the second region divided by the slope of the detection amount of Cu in the first region was greater than 0.5 in each graph of Cu of the bonded body according to the comparative example.

Also, the yield was good for the examples 1 and 3 to 9 of which the Ti amount inside the active metal brazing material was not less than 5 mass%. In contrast, in the example 2, the Ti amount inside the active metal brazing material was low and was 2 mass%, and so the yield decreased slightly.

Then, the ceramic circuit boards were made by patterning the bonded bodies of the examples and the comparative examples by etching. Tests of the bonding strength of the copper circuit, the electrical conductivity of the copper circuit, and the Ag migration were performed on the ceramic circuit board.

The bonding strength of the copper circuit was measured by a peel test. The measurement conditions of the peel test were as follows. First, a portion of the bonded copper circuit was peeled to make a clamp part by bending about a 10 mm portion of the peeled copper circuit to a right angle with respect to the ceramic substrate. By using a measuring stand, the clamp part was pulled at a constant speed (50.0 mm/min) with respect to the ceramic substrate. The average value of the scale values of a force gauge (a spring scale) was read while pulling.

Formula 1 below shows the relationship between a peel strength $\delta f$ (kgf/cm), a bonding width W (mm) of the copper circuit being pulled, and a measured value P (kgf). The peel strength $\delta f$ of Formula 1 was converted into a peel strength F (N/m) of SI units by Formula 2. The average value that was read from the force gauge was converted into the peel strength by Formula 2 below.

$$\delta f = (10/W){\times}P \qquad\qquad (1)$$

$$F = \delta f{\times}9.8{\times}10^2 \qquad\qquad (2)$$

For the electrical conductivity of the copper circuit, the resistance value was measured using a tester. Using the resistance value of the oxygen-free copper plate before bonding as 100, the ceramic circuit boards of which the resistance values of the copper circuits were not less than 90 were evaluated to be "maintained"; and the ceramic circuit boards of which the resistance values of the copper circuits were less than 90 were evaluated to be "reduced". For the examples and the comparative examples, the resistance values at ten locations of the ceramic substrate were measured, and the evaluation was "reduced" if the resistance value was less than 90 for even one location.

To evaluate the Ag migration characteristics, a voltage was applied to the ceramic circuit board at high temperature and high humidity; and the occurrence ratio of Ag migration filaments was checked. An electrochemical migration evaluation system by ESPEC Corp. was used as a measurement device. A load of an applied voltage of AC 2,000 V (a peak voltage of 2,820 V) was continuously applied to the ceramic circuit board for 30 hours in an environment of a temperature of 85 °C and a humidity of 85%. Subsequently, it was checked whether or not Ag migration filaments were present at the surface of the ceramic circuit board. One hundred ceramic circuit boards were evaluated for each of the examples and the comparative examples. The examples of which not less than 0 and not more than 5 of the ceramic circuit boards included one or more Ag migration filaments were evaluated to be "good". The examples of which not less than 6 of the ceramic circuit boards included one or more Ag migration filaments were evaluated to be "defective". The results are shown in Table 7.

[Table 7]

|  | Bonding strength (kN/m) | Copper plate electrical conductivity | Ag migration test |
|---|---|---|---|
| Example1 | 26 | Maintained | Good |
| Example2 | 27 | Maintained | Good |
| Example3 | 25 | Maintained | Good |
| Example4 | 25 | Maintained | Good |
| Example5 | 24 | Maintained | Good |
| Example6 | 27 | Maintained | Good |
| Example7 | 27 | Maintained | Good |

(continued)

|  | Bonding strength (kN/m) | Copper plate electrical conductivity | Ag migration test |
|---|---|---|---|
| Example8 | 26 | Maintained | Good |
| Comparative example1 | 27 | Reduced | Defective |
| Comparative example2 | 28 | Reduced | Defective |

It can be seen from Table 7 that the TCT characteristics and the Ag migration characteristics were improved for the examples compared to the comparative examples. Also, Sn migration was suppressed in the examples. Although the bonding strength was equal between the examples and the comparative examples, it can be seen that the performance as a ceramic circuit board was improved by improving the TCT characteristics and the Ag migration characteristics. Also, the reduction of the electrical conductivity of the copper plate was suppressed in the ceramic circuit boards according to the examples.

Configuration 1

A bonded body, comprising:

a ceramic substrate;
a copper plate; and
a bonding layer bonding the ceramic substrate and the copper plate,
the bonding layer including Ag, Cu, an active metal, and a first element,
the first element being one or two selected from Sn and In,
a detection amount (mass%) of the first element divided by a detection amount (mass%) of Ag at a first measurement point being within a range of not less than 0 and not more than 0.4 when any cross section of the bonded body is analyzed by SEM-EDX, and when a location at which a detection amount of Cu is not less than 80 mass% and at which a change of a slope in a graph of the detection amount of Cu is largest is taken as the first measurement point.

Configuration 2

The bonded body according to Configuration 1, wherein

the detection amount (mass%) of the first element divided by the detection amount (mass%) of Ag at the first measurement point is within a range of not less than 0.05 and not more than 0.2.

Configuration 3

The bonded body according to Configuration 1 or Configuration 2, wherein

a ratio of the slope of the detection amount of Cu in a second region to the slope of the detection amount of Cu in a first region in the graph is not more than 0.5,
the first region is a region from an interface between the ceramic substrate and the bonding layer to the first measurement point, and
the second region is a region at a side opposite to the first region with respect to the first measurement point.

Configuration 4

The bonded body according to any one of Configurations 1 to 3, wherein
the Ag detection amount at the first measurement point is within a range of not less than 3 mass% but less than 20 mass%.

Configuration 5

The bonded body according to any one of Configurations 1 to 4, wherein
a detection amount (mass%) of the active metal divided by the Ag detection amount (mass%) at the first measurement point is within a range of not less than 0 and not more than 0.1.

Configuration 6

The bonded body according to any one of Configurations 1 to 5, wherein

a detection amount (mass%) of Ag at a second measurement point divided by the detection amount of Ag at the first measurement point is within a range of not less than 0.1 and not more than 0.7, and
the second measurement point is a location shifted 10 µm from the first measurement point toward a front surface of the copper plate.

Configuration 7

The bonded body according to Configuration 6, wherein
a detection amount (mass%) of the first element divided by the detection amount (mass%) of Ag at the second measurement point is within a range of not less than 0 and not more than 0.1.

Configuration 8

The bonded body according to Configuration 6, wherein
a detection amount (mass%) of the active metal divided by the detection amount (mass%) of Ag at the second measurement point is within a range of not less than 0 and not more than 0.1.

Configuration 9

The bonded body according to any one of Configurations 1 to 8, wherein
a Ag diffusion region is present between the ceramic substrate and a point shifted 30 µm from the first measurement point toward a front surface of the copper plate.

Configuration 10

The bonded body according to any one of Configurations 1 to 9, wherein
a thickness of the copper plate is not less than 0.3 mm.

Configuration 11

The bonded body according to any one of Configurations 1 to 10, wherein
the ceramic substrate is a silicon nitride substrate.

Configuration 12

A ceramic circuit board, comprising:
a circuit configuration provided in the copper plate of the bonded body according to any one of Configurations 1 to 11.

Configuration 13

A semiconductor device, comprising:

the ceramic circuit board according to Configuration 12; and
a semiconductor element mounted to the copper plate in which the circuit configuration is provided.

Configuration 14

A method for manufacturing the bonded body according to any one of Configurations 1 to 11, the method comprising:

preparing a stacked body, the stacked body including

the ceramic substrate,
an active metal brazing material in which a content of the active metal is not less than 5 mass% and not more than 15 mass%, and
the copper plate; and

thermally bonding the ceramic substrate and the copper plate by using a continuous furnace.

While certain embodiments of the inventions have been illustrated, these embodiments have been presented by way of example only, and are not intended to limit the scope of the inventions. These novel embodiments may be embodied in a variety of other forms; and various omissions, substitutions, modifications, etc., can be made without departing from the spirit of the inventions. These embodiments and their modifications are within the scope and spirit of the inventions, and are within the scope of the inventions described in the claims and their equivalents. Also, the embodiments above can be implemented in combination with each other.

[Reference Numeral List]

1 bonded body
2 ceramic substrate
3 bonding layer
4 copper plate (front copper plate)
4a copper circuit
5 copper plate (back copper plate)
6 first measurement point
7 second measurement point
8 semiconductor element
10 ceramic circuit board
20 semiconductor device

**Claims**

1.  A bonded body (1), comprising:

    a ceramic substrate (2);
    a copper plate (4); and
    a bonding layer (3) bonding the ceramic substrate (2) and the copper plate (4),
    the bonding layer (3) including Ag, Cu, an active metal, and a first element,
    the first element being one or two selected from Sn and In,
    a detection amount (mass%) of the first element divided by a detection amount (mass%) of Ag at a first measurement point (6) being within a range of not less than 0 and not more than 0.4 when any cross section of the bonded body (1) is analyzed by SEM-EDX, and when a location at which a detection amount of Cu is not less than 80 mass% and at which a change of a slope in a graph of the detection amount of Cu is largest is taken as the first measurement point (6).

2.  The bonded body (1) according to claim 1, wherein
    the detection amount (mass%) of the first element divided by the detection amount (mass%) of Ag at the first measurement point (6) is within a range of not less than 0.05 and not more than 0.2.

3.  The bonded body (1) according to claim 1 or claim 2, wherein

    a ratio of the slope of the detection amount of Cu in a second region to the slope of the detection amount of Cu in a first region in the graph is not more than 0.5,
    the first region is a region from an interface between the ceramic substrate (2) and the bonding layer (3) to the first measurement point (6), and
    the second region is a region at a side opposite to the first region with respect to the first measurement point (6).

4.  The bonded body (1) according to claim 1 or claim 2, wherein
    the Ag detection amount at the first measurement point (6) is within a range of not less than 3 mass% but less than 20 mass%.

5. The bonded body (1) according to claim 1 or claim 2, wherein
a detection amount (mass%) of the active metal divided by the Ag detection amount (mass%) at the first measurement point (6) is within a range of not less than 0 and not more than 0.1.

6. The bonded body (1) according to claim 1 or claim 2, wherein

a detection amount (mass%) of Ag at a second measurement point (7) divided by the detection amount of Ag at the first measurement point (6) is within a range of not less than 0.1 and not more than 0.7, and
the second measurement point (7) is a location shifted 10 $\mu$m from the first measurement point (6) toward a front surface of the copper plate (4).

7. The bonded body (1) according to claim 6, wherein
a detection amount (mass%) of the first element divided by the detection amount (mass%) of Ag at the second measurement point (7) is within a range of not less than 0 and not more than 0.1.

8. The bonded body (1) according to claim 6, wherein
a detection amount (mass%) of the active metal divided by the detection amount (mass%) of Ag at the second measurement point (7) is within a range of not less than 0 and not more than 0.1.

9. The bonded body (1) according to claim 1 or claim 2, wherein
a Ag diffusion region is present between the ceramic substrate (2) and a point shifted 30 $\mu$m from the first measurement point (6) toward a front surface of the copper plate (4).

10. The bonded body (1) according to claim 1 or claim 2, wherein
a thickness of the copper plate (4) is not less than 0.3 mm.

11. The bonded body (1) according to claim 1 or claim 2, wherein
the ceramic substrate (2) is a silicon nitride substrate.

12. A ceramic circuit board (10), comprising:
a circuit configuration provided in the copper plate (4) of the bonded body (1) according to claim 1.

13. A semiconductor device (20), comprising:

the ceramic circuit board (10) according to claim 12; and
a semiconductor element (8) mounted to the copper plate (4) in which the circuit configuration is provided.

14. The bonded body (1) according to claim 6, wherein

a thickness of the copper plate (4) is not less than 0.3 mm, and
the ceramic substrate (2) is a silicon nitride substrate.

15. The bonded body (1) according to claim 7, wherein

a thickness of the copper plate (4) is not less than 0.3 mm, and
the ceramic substrate (2) is a silicon nitride substrate.

16. The bonded body (1) according to claim 6, wherein
a Ag diffusion region is present between the ceramic substrate (2) and a point shifted 30 $\mu$m from the first measurement point (6) toward the front surface of the copper plate (4).

17. The bonded body (1) according to claim 7, wherein
a Ag diffusion region is present between the ceramic substrate (2) and a point shifted 30 $\mu$m from the first measurement point (6) toward the front surface of the copper plate (4).

18. A ceramic circuit board (10), comprising:

a circuit configuration provided in the copper plate (4) of the bonded body (1) according to claim 14.

19. A ceramic circuit board (10), comprising:
a circuit configuration provided in the copper plate (4) of the bonded body (1) according to claim 15.

20. A ceramic circuit board (10), comprising:
a circuit configuration provided in the copper plate (4) of the bonded body (1) according to claim 16.

21. A method for manufacturing the bonded body (1) according to claim 1, the method comprising:

preparing a stacked body, the stacked body including

the ceramic substrate (2),
an active metal brazing material in which a content of the active metal is not less than 5 mass% and not more than 15 mass%, and
the copper plate (4); and

thermally bonding the ceramic substrate (2) and the copper plate (4) by using a continuous furnace.

1

4

3

2

3

5

FIG. 1

4

7

6

10µm

3

2

FIG. 2

FIG. 3

FIG. 4

FIG. 5

## INTERNATIONAL SEARCH REPORT

International application No.

**PCT/JP2023/023831**

### A. CLASSIFICATION OF SUBJECT MATTER

*C04B 37/02*(2006.01)i; *B32B 15/04*(2006.01)i; *H05K 1/03*(2006.01)i
FI: C04B37/02 B; B32B15/04 B; H05K1/03 610D

According to International Patent Classification (IPC) or to both national classification and IPC

### B. FIELDS SEARCHED

Minimum documentation searched (classification system followed by classification symbols)

C04B37/02; B32B15/04; H05K1/03

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | WO 2021/235387 A1 (TOSHIBA KK) 25 November 2021 (2021-11-25) paragraphs [0031], [0035]-[0048], tables 1-4, examples 13, 14 | 1-21 |
| X | WO 2022/024990 A1 (TOSHIBA KK) 03 February 2022 (2022-02-03) paragraphs [0031]-[0038], tables 2, 4, examples 1-5 | 1-21 |
| A | WO 2022/024832 A1 (TOSHIBA KK) 03 February 2022 (2022-02-03) entire text | 1-21 |
| A | WO 2022/075409 A1 (TOSHIBA KK) 14 April 2022 (2022-04-14) entire text | 1-21 |
| A | JP 5-024943 A (NGK INSULATORS LTD) 02 February 1993 (1993-02-02) entire text | 1-21 |

☐ Further documents are listed in the continuation of Box C.　　☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **12 September 2023** | **26 September 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT
Information on patent family members

International application No.

**PCT/JP2023/023831**

| Patent document cited in search report | | | Publication date (day/month/year) | Patent family member(s) | | | Publication date (day/month/year) |
|---|---|---|---|---|---|---|---|
| WO | 2021/235387 | A1 | 25 November 2021 | US | 2023/0080016 | A1 | |
| | | | | paragraphs [0079], [0097]-[0107], tables 1-4, examples 13-14 | | | |
| | | | | EP | 4155281 | A1 | |
| | | | | CN | 115667186 | A | |
| WO | 2022/024990 | A1 | 03 February 2022 | US | 2023/0140744 | A1 | |
| | | | | paragraphs [0088]-[0097], tables 2, 4, examples 1-5 | | | |
| | | | | CN | 116134607 | A | |
| WO | 2022/024832 | A1 | 03 February 2022 | US | 2023/0135530 | A1 | |
| | | | | entire text | | | |
| | | | | CN | 116134004 | A | |
| WO | 2022/075409 | A1 | 14 April 2022 | CN | 115989579 | A | |
| | | | | entire text | | | |
| JP | 5-024943 | A | 02 February 1993 | (Family: none) | | | |

Form PCT/ISA/210 (patent family annex) (January 2015)

23

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2017056360 A

- WO 2018199060 A